Europäisches Patentamt

(19) European Patent Office

Office européen des brevets

(11) Publication number: **0 087 985**
**A1**

## (12) EUROPEAN PATENT APPLICATION

(21) Application number: **83301123.2**

(22) Date of filing: **02.03.83**

(51) Int. Cl.³: **G 01 R 5/26**
**G 05 D 23/30, G 12 B 1/02**

(30) Priority: **03.03.82 NZ 199898**

(43) Date of publication of application:
**07.09.83 Bulletin 83/36**

(84) Designated Contracting States:
**AT BE CH DE FR GB IT LI LU NL SE**

(71) Applicant: **Goodwin, Paul Raymond**
**319 Queen Street**
**Auckland(NZ)**

(72) Inventor: **Goodwin, Paul Raymond**
**319 Queen Street**
**Auckland(NZ)**

(74) Representative: **Ayers, Martyn Lewis Stanley et al,**
**J.A. KEMP & CO. 14 South Square Gray's Inn**
**London, WC1R 5EU(GB)**

(54) Electrically heatable differential thermal expansion devices and/or methods of making the same and/or instruments using the said devices.

(57) A differential thermal expansion device comprising a narrow strip of two dissimilar materials having different co-efficients of thermal expansion and an applied flexible resistive electrical conductor which, when activiated by an electric potential, will cause dissimilar expansion. The device can be used as a coil in an electrical measuring instrument which can be calibrated in a number of ways. The invention also consists in a method of manufacture of the device.

FIG 1

- 1 -

"Electrically heatable differential thermal expansion devices and/or methods of making the same and/or instruments using the said devices".

This invention relates to electrically heatable differential thermal expansion devices and/or methods of making the same and/or instruments using the same device.

Electrically heatable bi-metallic strips have been used in various instruments and examples of typical constructions are shown in United States Patent Specification Nos. 2,575,728, 2,875,408 and 3,133,257. These constructions have the heater separate from the bi-metallic strip.

A meter is disclosed in United States Patent Specification No. 280,935 where a current flows through the bi-metallic strip for a very short period of time. This meter is used for fuse testing and would not have any application other than for the very short duration as specifically required with the fuse testing function.

It is an object of the present invention to provide electrically heatable differential thermal expansion devices and/or methods of making the same and/or instruments using the said devices which will provide some advantages over the constructions aforesaid or at least provide the public with a useful choice.

Accordingly in one aspect the invention consists in a method of manufacturing an electrically heatable differential thermal expansion means, said method comprising the steps of bonding together into a narrow strip two dissimilar materials each having a different co-efficient of thermal expansion and applying to the bonded strip a flexible resistive electrical conductor so that in use by applying an electric potential to the said conductor the bonded strips are heated so as to cause dissimilar expansion of the dissimilar materials in the said strip.

In a further aspect the invention consists in an electrically heatable differential thermal expansion means, said differential thermal expansion means comprising a narrow strip of two dissimilar materials bonded to each other, said materials having different temperature co-efficients of expansion, the strip having applied thereto a flexible resistive electrical conductor, construction and arrangement being such that on an electric potential being applied to the conductor, the strip will be heated so that one of said dissimilar materials expands at a greater rate than the other.

In a still further aspect the invention consists in an electrical measuring instrument comprising an electrically heatable differential thermal expansion means according to the preceding paragraphs, terminals where the conductor is connected in use to a source of electricity and indicator means having an indicator, the position of which is determined by the potential difference applied to said conductor.

The resistive conductor is formed by applying a film or coating of conductive resistance material to an insulated surface of a bi-metal strip.

The bi-metallic strip with the conductor material applied thereto is formed into a coil in the form of a spiral or helix.

Where the dissimilar materials are bi-metal the resistive conductor is applied as a film on an insulative layer first applied to at least one form of the bi-metal strip with the return electrical path being through the bi-metallic strip. The connection between the resistive coating and the bi-metallic strip can be made by a mechanical connection with for example a clip or by removing or omitting a section of the insulation at an appropriate position. The resistive electrical conductor is preferably a conductive ink applied in a suitable carrier.

The conductive ink has as the conducting particles a metal such as silver or copper. However, any suitable conductive material which may be used in this form would be acceptable.

It would also be possible to have a specially formed nichrome strip or other similar electrically conductive material which could be adhered to and insulated from the bi-metallic strip to achieve the same result.

The linear accuracy of an electric measuring instrument or meter incorporating the electrically heatable differential expansion means according to the present invention is controlled by a number of parameters including the number of turns in the coil and the length of the bi-metallic strip. It is therefore desirable to ensure that resistance required in the completed meter is provided by the resistive electrical conductor over the whole or substantially the whole operative length of the coil. This can be controlled by the film thickness and the resistivity of the resistive conductor so that the desired resistance is reached at or near the optimum length of the coil.

From a calibration point of view it is comparatively simple to test for the required resistance before the bi-metallic strip is coiled and provided this can be achieved in the range which will allow the desired physical configuration of the coil an acceptable result can be produced.

The coil according to the present invention when used in any instrument must be mounted in a suitable mounting base with the outer end of the coil firmly held in position and in a manner such that the electrical connections for the desired circuit can be made.

In addition to controlling the accuracy of the resistance in the flexible resistive electrical conductor associated with the coil it is also necessary to control the deflection. To allow this control to be effected so that the accurate calibration of the instrument may be effected a second movable support arm is provided also to engage with the bi-metallic strip. As this arm is moved the point from which the coil will effectively operate in use is adjusted thus controlling the effective length of the coil. In this way the calibration over the desired range can be effective.

The second movable support is preferably provided by a radial arm extending from the centre or pivot position of the meter and having a post with an engagement arm which will have the outer run or turn of the coil of the bi-metallic strip passing therethrough.

While the calibration may be controlled by varying the effective length of the coil is a significant factor it would be possible for the present invention to be implemented without this feature. In this instance the deflection control of the coil would be fixed with one length of coil and the desired coil configuration.

A tail of the coil comprising the same materials as the coil would extend beyond the bi-metallic coil to produce the desired resistance needed for the application of the meter and allow for adjustment by varying the effective resistance which would be applied to the coil.

In a further modification the desired parameters could be controlled by reducing the area of the flexible resistive electrical conductor associated with the bi-metallic strip in a controlled manner so that the desired resistance over the length is achieved.

A further modification possible would be to incorporate a variable resistor such as a wire wound variable resistor in the circuit to give the necessary control to enable appropriate calibration. However, with this approach there is introduced a separate and quite expensive item which is not required if the other approaches are adopted and hence while it cannot be excluded from the ambit of the invention commerically it is not a preferred embodiment.

One preferred form of the present invention will now be described with reference to the accompanying drawings in which:

Figure 1 is a partly diagrammatic plan view of a meter according to the present invention;

Figure 2 is a partly diagrammatical sectional elevation;

Figure 3 is an enlarged diagrammatic detail showing a section through a bi-metallic strip with the flexible resistive electrical conductor associated therewith, and

Figure 4 is a view showing a modified configuration with the flexible resistive electrical conductor.

In the preferred embodiment of the present invention reference will be made to the use of the invention in an instrument which could conveniently be used in the auxillary instrumentation panel of any automobile but it will be understood that the invention has a much broader application as has been set forth in the preceding sections of the specification.

An analogue dial meter 1 suitable for auxillary instrumentation in an automobile, for example for recording fuel, temperature, battery voltage etc., is constructed with a configuration which will depend upon the particular requirements of the individual automotive manufacturer. In the present drawings a diagrammatic presentation only is shown.

The principal operative component is the electrically heatable differential thermal expansion coil 2 which is formed from a narrow strip of two dissimilar materials such as a strip of bi-metallic material. The present invention is also intended to include a strip of two dissimilar materials which will in use in the applications contemplated by this invention function in essentially the same manner as a bi-metal strip. For example, two thermally distinct but high temperature plastics could be adapted to provide the strip of dissimilar material.

Any suitable bi-metallic strip can be adapted for the present invention and the configuration of the coil while important, is also capable of considerable variations. The control parameters of the coil are the length of the bi-metallic strip, the number of turns in the coil and the space between the turns. It is desirable to achieve a linear scale in the meter over quite a wide range and we have found that it is preferable to have approximately five turns or more in the coil to give linear accuracy over approximately 250°. The invention may be applied with a different coil configuration if it is accepted that the linear accuracy is required over a different and for example more limited range.

The coil is made up from a bi-metallic strip 2 which has been coated on one side with an insulating layer 4. It is preferable to prepare the strip by chemical etching before the insulating layer is applied. The requirement for moderately high service temperature and flexibility sufficient to allow coiling limits the insulating material which can be used. A material selected has been an insulating resin 55 H-D produced by Electro Science Laboratories Inc. This is a modified imide polymer. The information is supplied as an example only and other materials having the desired properties would also be available. The insulating layer 4 is applied as a thick varnish like consistency with a solids content of 15 to 20%. When properly dried and cured it adheres extremely well to the bi-metallic strip. It withstands high temperatures (up to 250°C continuous) and has a high di-electric strength.

It is necessary to place a flexible resistive electrical conductor on the insulating layer 4. This conductive film 5 is produced by mixing an appropriate conductor with a suitable carrier. Again a wide range of materials could be selected and by way of example a silver filled organic paste I-30 produced by Electro Science Laboratories Inc., can be mixed with the 55 H-D resin.

Any suitable method of application can be adopted. It would be possible for the material to be sprayed on or applied by a roller. It would also be possible for a screen printing process to be used. In selecting the process care must be taken to avoid bubble formation. It is desirable to ensure that the resistive material should be deposited in as even a layer as possible to provide an even distribution of heat along the strip and also to allow for a reproducible or substantially reproducible resistance to be achieved.

Experience has shown that with the relatively low solid content of the material acceptable results can be achieved with a single brush application method.

The method of application could involve a very thin film of the resistive coating being first applied and a second coating being formed on the first coating but provided the film is even a single coating is acceptable.

Appropriate curing cycles will need to be provided both for the insulation and the resistive electrical conductor.

It is also desirable to use a post cure electrical burn in production. This operates as a safeguard against resistance shifts occurring in use and requires a higher voltage to be applied than the maximum service rating. It may also be desirable for the insulation to be applied with more than one coating.

The particles employed in the manufacture of the conductive ink are significant. Silver is the preferred metal for two reasons. It resists oxidation and has the highest conductivity. Another significant factor is that silver in the form required is readily available. It is preferred to have the silver or any other metallic particle in the flake powder form. The flake should have an average diameter of one micron and be up to thirty microns long by way of example silver flakes manufactured by Johnson Matthey Chemical Limited in grades $FS_2$, $FS_4$ and $FS_6$ are suitable.

The metallic flakes and preferably silver flakes are throughly mixed with the 55 H-D polymide based resin. The ratio by volume is approximately one to three of $FS_4$ to 55 H-D resin. As many factors influence the change in resistivity of the cured mix it is necessary to sample the mix before full scale use and then to adjust the ratio of the ingredients to produce the required result.

The viscosity of the resin 55 H-D should be checked before use and preferably should lie between eight thousand to fifty thousand CES.

By way of example the following procedure could be adopted:

(1) apply three layers of the insulation resin with each layer dried at 100°C for twenty minutes and subsequently cured at 200°C for thirty minutes,

(2) apply the resistive film dried at 120°C for thirty minutes and cured at 250°C for two hours,

(3) post cure electrical burn in with a voltage 25% above maximum service rating for one minute.

In mechanisation the process may be modified and the process could in sections or totally be continuous.

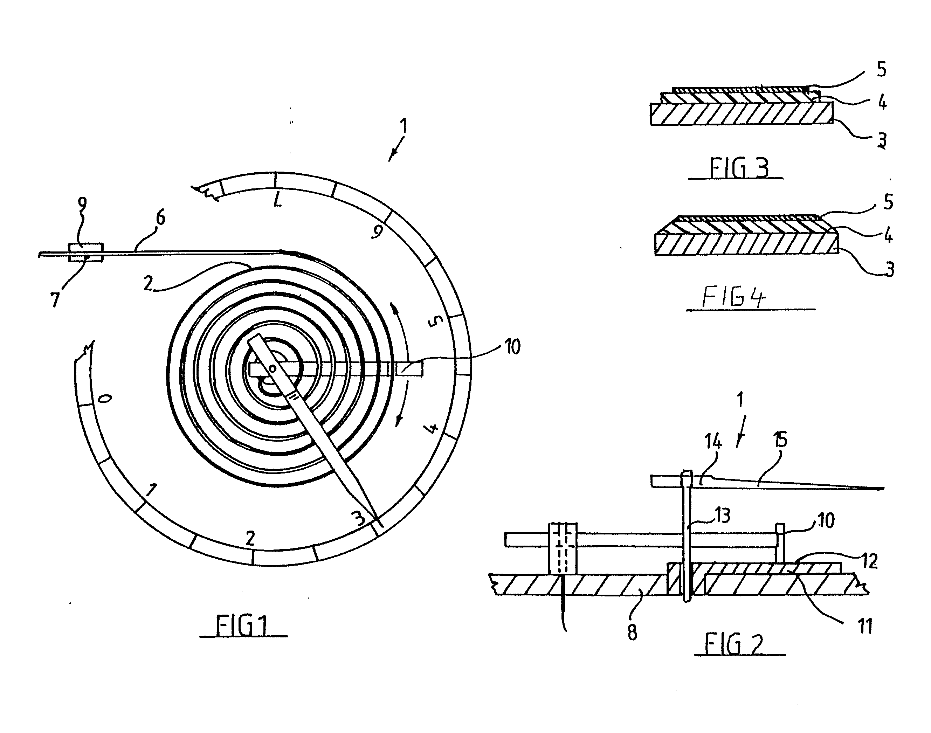

Care is required to ensure that the insulation at the edge of the strip is adequate. This can be achieved as indicated in Figure 3 by confining the resistive coating 5 well within the boundaries of the insulated layer 4. Alternatively, less care can be taken with the boundaries of the layers 4 and 5 and a subsequent processing step introduced to cut away and bevel back the layers as illustrated in Figure 4.

While there is considerable advantage from using a resistive film as above described to produce the flexible resistive electrical conductor the present invention would then also work if a thin micron resistor of appropriate configuration usually a strip of substantially the same width as the bi-metal strip was adhered to the surface of the bi-metalic strip again preserving the insulation between the metal and the resistor to avoid any short circuit. The invention in this regard is not limited to any specific resistance material but the material selected must be sufficiently flexible and ductile to operate in the desired configuration such as the coil configuration above described.

The shape of the coil is not critical, it may be a spiral or helix. However, it is desirable but by no means essential to ensure that the resistive coating is on the inside of the bi-metallic strip as coiled in this position the material is subject to less stress. A configuration could involve two layers of metal with an insulating layer therebetween. The metal would provide the differential thermal expansion and also the resistance required for electrical heating.

It is necessary to test the resistance of the coil. This can be simply done manually or a suitable production  technique adopted which will automatically test the completed coil. The electrical configuration of the coil is preferably one where the resistance coating is electrically in contact with  the bi-metallic strip towards the inner end of the coil either by some mechanical connector such as a clip or with a section of the resistance being removed. This provides a return electrical path through the bi-metallic strip. While such configuration has many advantages it is not essential and the circuit could be completed in other ways.

The circuit however completed would normally be made while the strip was uncoiled and the test undertaken to produce the desired resistance associated with the bi-metallic strip. The determined length of the bi-metallic strip would then be coiled around a mandrel to produce a coil with the resistance coating on the inside of the coil. Where a linear range of approximately 250° is required the number of turns in the coil would be at least 5 and preferably 6. The end 6 of the coil is engaged in a mounting block 7 protruding from a base 8. The design of the mounting block is not critical although it is clearly desirable to ensure it facilitates easy assembly and enables the necessary electrical connections to be made. In one form the mounting block has a slot longitudinally extending therethrough with the bi-metallic strip pushed into the slot. On one face of the slot there is located a pin 7 which protrudes and is associated with an electrical connection to allow an electrical lead readily to be connected thereto in use. The pin makes the contact with the resistive coating on the coil. The other part of the circuit is completed by a coupling with the bi-metallic strip at the centre or end of the coil.

The coil is thus located in one position by the post 9. A second position control post 10 is used to regulate the effective length of the coil in use and hence control the deflection of the indicator. This post 10 is preferably carried on an arm 11 rotatable about the centre point of the meter. The post 10 has a slot through which the bi-metallic strip passes and the arm 11 projects beyond the post to give a gripping member 12 which can be gripped by an operator using an appropriate instrument to rotate the arm and hence adjust its position and the effective length of the coil during the calibration process. This is an important control in the effective utilisation of the invention in instrumentation.

A central indicator shaft 13 rises through an aperture in the centre pivot of the meter and this shaft is connected by a suitable physical connection with the inner end of the coil 2 and carries an indicator arm preferably connected through a cap 14 which incorporates an ambient temperature compensator, for example using a bi-metallic strip counterwound to that of the coil.

Depending on the arrangement the coil can be made easily to expand or contract in the preferred arrangement. The ambient temperature compensation may be achieved using a thermister in the circuit and this could be a technique preferred to that of the bi-metallic counter-wound cap. The configuration and construction of a compensator is not critical to the performance of the invention provided that appropriate compensation is built into the instrument. The present invention would normally require some means for calibration. If the resistance could be controlled within close enough tolerances this may not be essential, for example using a nichrome strip precisely manufactured to the designed resistance valve. Calibration in other forms is possible. The resistive film may be "trimmed" using a lazer or similar technique. The coil may have a tail beyond the anchor and the point of electrical connection varied on the tail or the coil could be moved through the anchor point itself.

The present invention provides a comparatively simple and cheap means of constructing an electrically heatable differential thermal expansion device which can be arranged and calibrated effectively to produce the operating mechanism, an instrument responsible to varying potential differences and is thought to have particular application to the auxillary instrumentation at present employed in an automobile.

The present invention has a number of advantages over comparable existing coilage. It will be understood that the type of indirectly heated meter is suitable for the automotive industry but by virtue of the nature of the meter the movement inertia is very slow and hence its utilization is best in the fuel gauges, temperature gauges and oil gauges at present in most motor vehicles. With the conventional meter at present used in this area in the automotive field the accuracy is plus or minus 10%. The present meter will achieve an accuracy of plus or minus 5% which is a big advantage. The present invention provides a meter with a wide angle of deflection which can accurately be calibrated. This can be contrasted with the existing meters where the calibration can be restricted to approximately 110°. Deflection of up to 360° is possible with the present invention. Also it is expected that the costs of the present meter will be significantly less that existing meters.

The present invention provides a comparatively simple and cheap means of constructing an electrically heatable differential thermal expansion device which can be arranged and calibrated effectively to produce the operating mechanism an instrument responsible to varying potential differences and is thought to have particular application to the auxillary instrumentation at present employed in an automobile.

Claims:

1. A method of manufacturing an electrically heatable differential thermal expansion means said method comprising the steps of bonding together into a narrow strip two dissimilar materials each having a different co-efficient of thermal expansion and applying to the bonded strip a flexible resistive electrical conductor to an insulated surface of the dissimilar material so that in use by applying an electrical potential to the said conductor the bonded strips are heated so as to cause dissimilar expansion of the dissimilar materials in the said strip.

2. A method as claimed in claim 1 wherein the resistive conductor is applied an even thickness film or coating of conductive ink made up by mixing a temperature resistant resin with conductive particles said film or coating having the desired electrical resistance characteristics and applying said film or coating to an insulated surface of the dissimilar material.

3. A method as claimed in claim 1 wherein the flexible resistive electrical conductor is applied by fixing to an insulated surface of the dissimilar material a strip of electrically conductive material such as a nichrome strip having a desired resistive property.

4. A method as claimed in claim 2 or claim 3 wherein the strip of dissimilar material is a bi-metal strip including the step of coating the surface to which the flexible resistive electrical conductor is to be applied with a flexible temperature resisting insulating resin as one or more coats.

5. A method as claimed in claim 4 including the step of forming the strip into a multi-turn spiral or helix mounted towards its outer end and supporting an indicator on the inner end of said coil with calibration effected by adjusting the effective operative length or resistance of the coil.

6. An electrically heatable differential thermal expansion means said differential thermal expansion means comprising a narrow strip of two dissimilar materials bonded to each other said materials having different temperature co-efficients of expansion, the strip having applied thereto a flexible resistive electrical conductor the construction and arrangement being such that on an electrical potential being applied to the conductor the strip will be heated so that one of said dissimilar materials expands at a greater rate than the other.

7. A differential thermal expansion means as claimed in claim 6 wherein the resistive coating comprises a film or coating of conductive particles disbursed through a temperature resistant resin of resistance material applied to an insulated surface of the dissimilar material.

8. A differential thermal expansion means as claimed in claim 6 wherein the flexible resistive conductor comprises a flat strip of suitable resistance material such as nichrome wire fixed to an insulated surface of said dissimilar material.

9. A differential thermal expansion means as claimed in claim 6 wherein the dissimilar material comprises a bi-metal strip with an insulating layer provided between the bi-metal strip and the flexible electrical conductor and with a return electrical path.

10. A differential thermal expansion means as claimed in Claim 9 wherein the strip is formed into a multi-turn coil or helix having five or more turns with the outer end of the coil anchored in a mounting base in a manner which will enable electrical connections to be made to the coil and with the inner end of the coil operatively associated with an indicator to be moved by a differential movement in said coil.

11. A differential thermal expansion means as claimed in claim 10 including an adjustable arm rotatably mounted to allow the arm to be moved along the coiled strip away from the anchor position to control the effective length of the coil and allow for calibration.

12. A differential thermal expansion means as claimed in claim 6 wherein calibration of the coil may be effected by adjusting the resistance in the resistive conductor on the coil.

13.     An electrical measuring instrument comprising
support means,
electrically heatable differential thermal expansion means
carried by said support means, said differential thermal expansion
means comprising an electrically heatable differential thermal expansion means comprising a narrow strip of two dissimilar materials
bonded to each other, said materials having different temperature co-
efficients of expansion, the strip having applied thereto a flexible
resistive electrical conductor the construction and arrangement being
such that on an electrical potential being applied to the conductor
the strip will be heated so that one of said dissimilar materials
expands at a greater rate than the other,
connection means to allow electrical connection so as to heat
the flexible resistive electrical conductor and
indicator means dependent for a reading on the calibratable
movement of said differential thermal expansion means upon the application of an electrical potential to said connection means.

14.     An apparatus that is claimed in claim 13 wherein the said
narrow strip is in form of a coil and said indicator means can be
calibrated by using means to selectively anchor to said support means
different portions of said strip.

15.     A differential thermal expansion means comprising a narrow
strip of two dissimilar materials bonded to each other, said materials
having different temperature co-efficients of expansion, the strip
having applied thereto a flexible resistive electrical conductor the
construction and arrangement being such that on an electrical potential being applied to the conductor the strip will be heated so that
one of said dissimilar materials expands at a greater rate than the
other, and being further characterised in that the strip is formed
into a multi-turn coil or helix having five or more turns with the
outer end of the coil anchored in a mounting base in a manner which
will enable electrical connections to be made to the coil and with the
inner end of the coil operatively associated with an indicator to be
moved by a differential movement in said coil.

FIG 3

FIG 4

FIG 1

FIG 2

0087985

European Patent
Office

**EUROPEAN SEARCH REPORT**

| | DOCUMENTS CONSIDERED TO BE RELEVANT | | EP 83301123.2 |

| Category | Citation of document with indication, where appropriate, of relevant passages | Relevant to claim | CLASSIFICATION OF THE APPLICATION (Int. Cl. 3) |
|---|---|---|---|
| X | AT - B - 275 191 (VDO TACHOMETER WERKE) <br> * Fig. 1-3; pages 5-9 * <br> * Fig. 2,3 * | 1,3,6, 8,9 13,15 | G 01 R 5/26 <br> G 05 D 23/30 <br> G 12 B 1/02 |
| X | DE - A1 -2 847 186 (SCHWARZ) <br> * Claim 2 * | 1,6 | |
| A | DE - B - 2 049 494 (NISSAN MOTOR CO) <br> * Fig. 2; claim 1 * | 1,6,13 | |
| A | CH - A - 456 728 (GENERAL ELECTRIC) <br> * Fig. 2,3 * | 6,13, 15 | TECHNICAL FIELDS SEARCHED (Int Cl 3) |
| A | FR - A - 2 087 184 (BIRAUD) <br> * Fig. 1 * | 1,3,4, 5,6,10, 13,15 | G 01 R 5/00 <br> G 05 D 23/00 <br> G 12 B 1/00 |
| A | US - A - 4 114 681 (DENNY) <br> * Fig. 2,3 * | 6,10, 13,14, 15 | H 01 H 37/00 |
| A | US - A - 3 975 703 (ANDRESEN) <br> * Fig. 1,3 * | 6,10, 13,14, 15 | |
| A | US - A - 3 758 030 (OSHEROFF) <br> * Fig. 1,2 * | 6,10, 11,13, 14,15 | |

The present search report has been drawn up for all claims

| Place of search <br> VIENNA | Date of completion of the search <br> 19-05-1983 | Examiner <br> KUNZE |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

European Patent
Office

| DOCUMENTS CONSIDERED TO BE RELEVANT | | CLASSIFICATION OF THE APPLICATION (Int. Cl.³) |
|---|---|---|
| Category | Citation of document with indication, where appropriate, of relevant passages | Relevant to claim | |
| A | US - A - 3 339 043 (BAAK)<br>   * Fig. 1,2 *<br><br>-- | 6,10,<br>13,14,<br>15 | |
| A | US - A - 2 352 439 (LANDON)<br>   * Fig. 1; column 1, lines 41-46 *<br><br>-- | 6,8,9,<br>13,15 | |
| D,A | US - A - 2 875 408 (PETZINGER)<br>   * Fig. 3,6 *<br><br>---- | | |

TECHNICAL FIELDS
SEARCHED (Int. Cl.³)

EPO Form 1503.2   06.78